# EUROPEAN PATENT SPECIFICATION

(11) **EP 4 343 342 B1**
(45) Date of publication and mention of the grant of the patent: **02.12.2026**
(21) Application number: 22197473.6
(22) Date of filing: 23.09.2022
(51) Int. Cl.: G01R 31/00, G01R 31/50, G01R 31/52

(54) **AIRCRAFT GROUND FAULT DETECTION CIRCUIT AND METHOD OF CALIBRATING AN AIRCRAFT GROUND FAULT DETECTION CIRCUIT**
SCHALTUNG ZUR ERKENNUNG EINES ERSCHLUSSES IN FLUGZEUGEN UND VERFAHREN ZUR KALIBRIERUNG EINER SOLCHEN SCHALTUNG
CIRCUIT DE DÉTECTION DE DÉFAUT DE MISE À LA TERRE POUR AÉRONEF ET PROCÉDÉ D'ÉTALONNAGE D'UN TEL CIRCUIT

(43) Date of publication of application: 27.03.2024
(73) Proprietor: HS Elektronik Systeme GmbH, 86720 Noerdlingen (DE)
(72) Inventor: Greither, Markus, 86154 Augsburg (DE)
(74) Representative: Schmitt-Nilson Schraud Waibel Wohlfrom Patentanwälte Partnerschaft mbB

(56) References cited:
- US-A1- 2017 259 927
- US-A1- 2017 261 563
- US-A1- 2020 191 851

## Description

The present invention is related to an aircraft ground fault detection circuit and to a method of calibrating such an aircraft ground fault detection circuit. The invention is further related to a method of operating an aircraft ground fault detection circuit, to an aircraft solid state power controller comprising an aircraft ground fault detection circuit, and to an aircraft comprising such an aircraft solid state power controller.

Modern aircraft usually comprise at least one aircraft power controller, in particular an aircraft solid state power controller ("SSPC"), for controlling the supply of electric power from an electric power supply to at least one electric load within an aircraft. The at least one aircraft power controller may in particular comprise a ground fault detection circuit, which is configured for detecting ground faults and switching of the supply of electric power by the at least one aircraft power controller in case a ground fault is detected.

US 2017/261563 A1 discloses an electronics system that comprises a heating circuit and a fault detection system. The heating circuit includes a heating element. The fault detection system includes a first resistor comprising a first resistance, a second resistor comprising a second resistance, the first resistance being equal to the second resistance, a voltage level detector, and a controllable switch connected in series with the first resistor and the second resistor, the controllable switch in electronic communication with the voltage level detector. A fault may be detected in response to the first voltage being greater than the second voltage.

It would be beneficial to provide an- improved aircraft ground fault detection circuit and an improved method of calibrating an aircraft ground fault detection circuit in order to increase the safety of an aircraft by enhancing the reliability of the aircraft ground fault detection circuit. It further would be beneficial to provide and improved aircraft ground fault detection circuit and an improved method of calibrating an aircraft ground fault detection circuit which allow reducing the risk of false alarms in which the at least one aircraft power controller is switched off due to an erroneous detection of a non-existing ground fault.

According to an exemplary embodiment of the invention, an aircraft ground fault detection circuit comprises a first electric power supply line, a second electric power supply line; a first shunt resistor, which is arranged in the first electric power supply line; a second shunt resistor, which is arranged in the second electric power supply line; a first voltage detector configured for detecting a first voltage drop over the first shunt resistor; and a second voltage detector configured for detecting a second voltage drop over the second shunt resistor. The aircraft ground fault detection circuit further comprises a first electric switch arranged in the first electric power supply line and/or a second electric switch arranged in the second electric power supply line, and a dedicated electric test current power supply, which is configured for applying an electric test voltage to the first and second electric power supply lines for causing an electric test current to flow through the first and second electric power supply lines and the first and second shunt resistors. The aircraft ground fault detection circuit comprises a controller, which is configured for receiving voltage signals provided by the first and second voltage detectors indicating the first and second voltage drops and for switching off at least one of the first and second electric switches if the absolute value of the difference between the first and second voltage drops minus an offset voltage, which is calculated from a difference between the resistivities of the first and second shunt resistors, exceeds a predetermined threshold. The controller is further configured for calibrating the aircraft ground fault detection circuit by determining a difference between the resistivities of the first and second shunt resistors from the first and second voltage drops voltage drops, when the electric test voltage is applied to the first and second electric power supply lines, and by calculating the offset voltage from the difference between the resistivities of the first and second shunt resistors

Exemplary embodiments of the invention further include a method of calibrating an aircraft ground fault detection circuit comprising a first electric power supply line; a second electric power supply line; a first shunt resistor arranged in the first electric power supply line; a second shunt resistor arranged in the second electric power supply line; a first voltage detector, which is configured for detecting a first voltage drop over the first shunt resistor; a second voltage detector, which is configured for detecting a second voltage drop over the second shunt resistor; and a controller, which is configured for receiving voltage signals provided by the first and second voltage detectors indicating the first and second voltage drops, and for switching off at least one of the first and second electric switches if the absolute value of the difference between the first and second voltage drops minus an offset voltage, which is calculated from a difference between the resistivities of the first and second shunt resistors, exceeds a predetermined threshold. The method includes the steps of applying an electric test voltage to the first and second electric power supply lines for causing an electric test current to flow through the first and second electric power supply lines and the first and second shunt resistors; receiving voltage signals from the first and second voltage detectors indicating the voltage drop over the respective shunt resistor; determining a difference between the resistivities of the first and second shunt resistors from said voltage drops; and calculating an offset voltage from the difference between the resistivities of the first and second shunt resistors.

An aircraft ground fault detection circuit and a method of calibrating such an aircraft ground fault detection circuit according to exemplary embodiments of the invention allow determining differences between the resistivities of the first and second shunt resistors by causing a predefined test current to flow though the two shunt resistors and measuring the voltage drops at the two shunt resistors, which are caused by the predefined test current. The test current is driven by a dedicated electric test current power supply. This allows calibrating the aircraft ground fault detection circuit with a voltage that is different, in particular lower, than the voltage applied to the aircraft ground fault detection circuit during normal operation. It further allows calibrating the aircraft ground fault detection circuit when the aircraft electric power supply, which is configured for applying voltage to the aircraft ground fault detection circuit during normal operation, is not available or not operating.

The test voltage that is applied by the electric test power supply may for example be a DC voltage in the range of between +/- 10 V and +/- 50 V, in particular an electric DC test voltage of +/- 28 V, which is often used in aircraft.

The first electric power supply line may be electrically connected to a negative pole of the electric test current power supply, and the second electric power supply line may be electrically connected to a positive pole of the electric test current power supply.

The controller may be configured for switching off at least one of the first and second electric switches before activating the electric test current power supply in order to separate the aircraft ground fault detection circuit from the aircraft electric power supply, which is provided for supplying electric power to the aircraft ground fault detection circuit during normal operation. Separating the aircraft ground fault detection circuit from the aircraft electric power supply during the calibration prevents electric currents that are driven by the aircraft electric power supply from interfering with the calibration.

The aircraft ground fault detection circuit may comprise two electric switches, with one of the two electric switches being arranged in each of the electric power supply lines, respectively. The two electric switches may allow separating both electric power supply lines from the aircraft electric power supply during the calibration.

Alternatively, the electric test current, which is used for the calibration, may flow through one of the two electric switches. In consequence, only one of the electric power supply lines may be separated from the aircraft electric power supply by switching off the other one of the two electric switches.

During normal operation, i.e. after the calibration has been completed, the controller may be configured for monitoring the voltage drops over the two shunt resistors and for switching off at least one, in particular both, of the first and second electric switches, if the absolute value of the difference between the first and second voltage drops minus a previously determined offset voltage, which has been calculated from the difference between the resistivities of the first and second shunt resistors, exceeds a predetermined threshold.

The absolute value of the difference between the first and second voltage drops minus the previously determined offset voltage exceeding a predetermined threshold may indicate a ground fault. Switching off at least one of the first and second electric switches may prevent further damage an/or injuries caused by an undesirable electric current ("ground fault current") that is flowing uncontrolled due to the ground fault.

The predetermined threshold, at which the controller switches off at least one of the first and second electric switches, may correspond to a difference between the electric currents flowing through the first and second shunt resistors in the range of 15 mA to 100 mA, more particular to a difference between the electric currents flowing through the first and second shunt resistors of 30 mA. Setting the predetermined threshold to one of these values prevents humans from being killed or severely injured by ground fault currents. It further reduces the risk of erroneously switching of the supply of electric power due to a "false alarm", when no ground fault is present.

In order to prevent humans from being killed or severely injured by ground fault currents, the controller may be configured to switch off at least one of the first and second electric switches within 30 ms after a ground fault has been detected.

The first and second electric switches may include field effect transistors (FET), in particular metal-oxide-semiconductor field-effect transistors (MOSFET). Field effect transistors, in particular metal-oxide-semiconductor field-effect transistors, provide reliable electric switches, which are able to switch high voltages and large currents within short periods of time. Field effect transistors and metal-oxide-semiconductor field-effect transistors have a long lifetime and are available at reasonable costs.

The first and second electric switches may also include insulated-gate bipolar transistors (IGBTs.)

The first and second electric switches may include transistors of the same type. Both electric switches may, for example, include n-channel field effect transistors, or both electric switches may, for example, include p-channel field effect transistors.

Using the transistors of the same type for both electric switches reduces the number of different parts comprised in the aircraft ground fault detection circuit. As a result, the costs for manufacturing the aircraft ground fault detection circuit may be reduced.

Alternatively, the first electric switch may include a field effect transistor having an n-channel, and the second electric switch may include a field effect transistor having a p-channel. Since the direction of the flow of the electric current is opposite in the first and second power supply lines, it may be beneficial to use different types of transistors in the first and second power supply lines, respectively. Using different, in particular complementary, types of transistors in the two electric switches may therefore result in a more simple, in particular in a more symmetric, configuration of the aircraft ground fault detection circuit.

The first and second switches are configured for switching voltages of at least 250 V, in particular voltages of at least 270 V. This allows switching the voltages that are commonly used in aircraft electric power supply systems.

Exemplary embodiment of the invention also include an aircraft solid state power controller comprising two input nodes ("power supply side nodes"), which are configured for being electrically connected to an aircraft electric power supply and two output nodes ("load side nodes"), which are configured for being electrically connected to a least one electric load. The aircraft solid state power controller further comprises an aircraft ground fault detection circuit according to an exemplary embodiment of the invention, which is provided between the power supply side nodes and the load side nodes of the aircraft solid state power controller for monitoring and controlling the electric currents flowing between the power supply side nodes and the load side nodes of the aircraft solid state power controller.

The aircraft solid state power controller further comprises a diode, in particular a free-wheeling diode, which is connected between the load side nodes of the aircraft solid state power controller. The diode is polarized for blocking during normal operation and for dissipating inductive voltages, which may be induced within an inductive electric load connected to the load side nodes of the aircraft solid state power controller, when the supply of electric power to the inductive electric load is switched off.

The test current power supply may be polarized so that the electric test current, which is driven by the test current power supply, is not blocked but passes the diode. In other words, the voltage applied by the test current power supply may be polarized inverse to the voltage supplied by the aircraft electric power supply.

Such a polarization of the test current power supply and the diode allows the electric test current to flow through the aircraft ground fault detection circuit even if no load is electrically connected to the load side nodes. In consequence, the aircraft ground fault detection circuit may by calibrated without an electric load being present. This facilitates the calibration of the aircraft ground fault detection circuit. The aircraft ground fault detection circuit may in particular be calibrated before it is installed in an aircraft and connected to at least one electric load.

Exemplary embodiment of the invention further include an aircraft comprising an aircraft electric power supply and an aircraft solid state power controller according to an exemplary embodiment of the invention, wherein the aircraft solid state power controller is connected to the aircraft electric power supply for supplying electric power from the aircraft electric power supply to at least one electric load.

Exemplary embodiments of the invention further include a method of operating an aircraft ground fault detection circuit according to an exemplary embodiment of the invention, wherein the method includes calibrating the aircraft ground fault detection circuit by executing the method for calibrating the aircraft ground fault detection circuit according to an exemplary embodiment of the invention, and wherein the method further includes continuously or repeatedly measuring and comparing the electric voltage drops over the first and second shunt resistors with each other, and switching off at least one of the first and second electric switches in case the absolute value of the difference between the first and second voltage drops minus the offset voltage, which has been calculated from the difference between the resistivities of the first and second shunt resistors, exceeds a predetermined threshold.

Such a method allows reliably detecting ground faults in the electric circuitry of an aircraft. Thanks to the calibration of the aircraft ground fault detection circuit differences in the resistivities of the shunt resistors, which are employed in the aircraft ground fault detection circuit, may be compensated and do not adversely affect the reliability of the ground fault detection.

In the following, an exemplary embodiment of an aircraft ground fault detection circuit will be described is described in more detail with reference to the enclosed figures.

Figure 1 depicts a schematic side view of an aircraft comprising an aircraft g solid state power controller according to an exemplary embodiment of the invention.

Figure 2 depicts a circuit diagram of an aircraft solid state power controller comprising an aircraft ground fault detection circuit according to an exemplary embodiment of the invention.

Figure 3 depicts a circuit diagram of an aircraft solid state power controller comprising an aircraft ground fault detection circuit according to another exemplary embodiment of the invention.

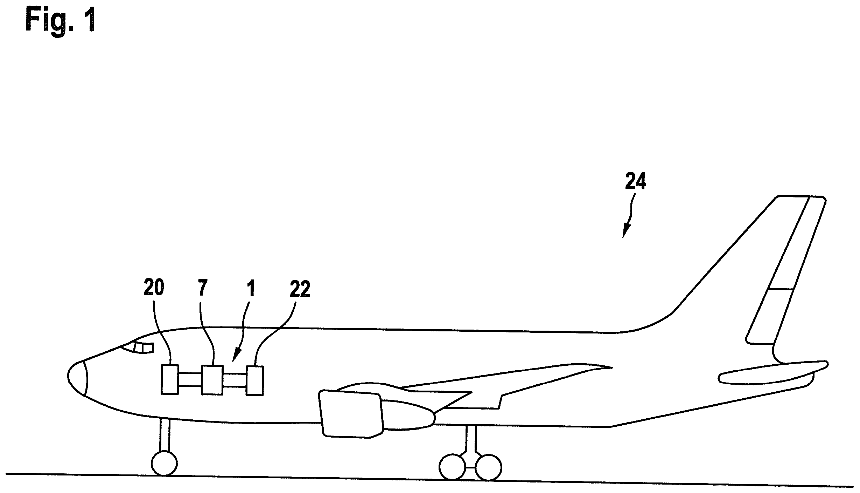

Figure 1 depicts an aircraft 24 comprising an electric circuit 1 including an electric electric power supply 20, an electric load 22, and an aircraft power controller 7 that is configured for controlling the supply of electric power from the electric electric power supply 20 to the electric load 22.

Although only a single electric load 22 is depicted in Figure 1, a plurality of electric loads 22 may by electrically connected to the aircraft power controller 7. An aircraft 24 may also comprise a plurality of electric circuits 1, with each electric circuit 1 comprising an aircraft power controller 7 according to an exemplary embodiment of the invention.

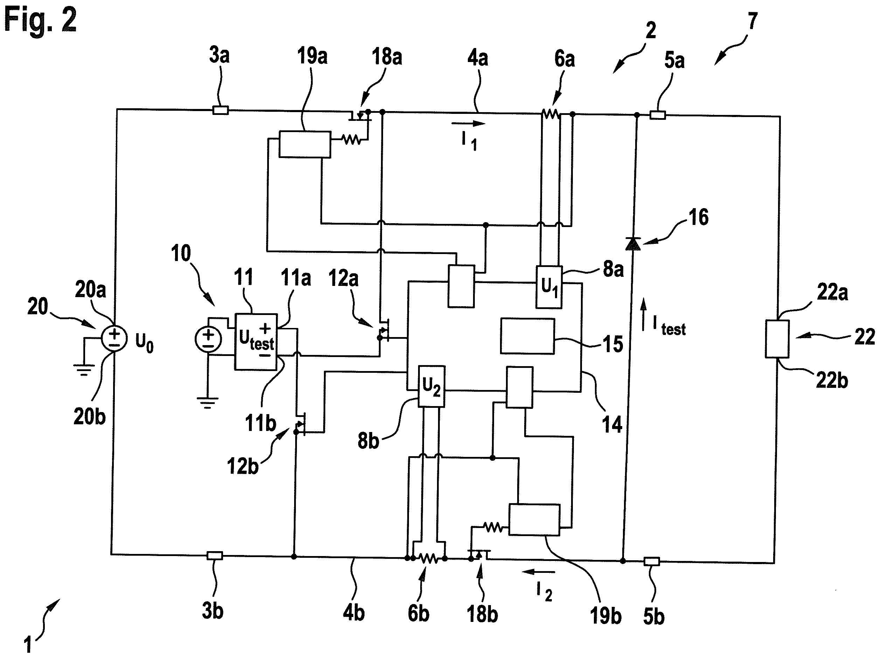

Figure 2 depicts a circuit diagram, of an aircraft power controller 7 according to an exemplary embodiment of the invention. The aircraft power controller 7 is in particular a solid state power controller 7.

The aircraft solid state power controller 7 comprises a first electric power supply line 4a extending between a first power supply side node ("input node") 3a, which is to be connected to a first (positive) pole 20a of an electric electric power supply 20, and a first load side node ("output node") 5a, which is to be connected to a first pole 22a of at least one electric load 22.

The aircraft ground fault detection circuit 2 further comprises a second electric power supply line 4b extending between a second power supply side node 3b, which is to be connected to a second (negative) pole 20b of an electric power supply 20, and a second load side node 5b, which is to be connected to a second pole 22b of the at least one electric load 22.

A first electric switching device 18a, in particular a solid state power control device, is arranged in the first electric power supply line 4a, and a second electric switching device 18b, in particular a solid state power control device, is arranged in the second electric power supply line 4b. The first and second electric switching devices 18a, 18b allow for controlling, in particular switching, the supply of electric power from the electric power supply 20 to the electric load 22 via the first and second electric power supply lines 4a, 4b.

A free-wheeling diode 16 is connected to the first and second load side nodes 5a, 5b. The free-wheeling diode 16 is polarized so that it blocks in normal operation, when a positive voltage is applied to the first electric power supply line 4a and a negative voltage is applied to the second electric power supply line 4b.

The free-wheeling diode 16 is provided for dissipating inductive voltages, which may be induced by inductive loads 22 between the first and second electric power supply lines 4a, 4b, when the first and second electric switching devices 18a, 18b are switched off.

The aircraft solid state power controller 7 further comprises an aircraft ground fault detection circuit 2, which is configured for detecting ground faults and switching off the supply of electric power to the at least one electric load 22, when a ground fault is detected.

The aircraft ground fault detection circuit 2 includes a first shunt resistor 6a, which is arranged in the first electric power supply line 4a, and a second shunt resistor 6b, which is arranged in the second electric power supply line 4b. In consequence. any electric current I₁ flowing through the first electric power supply line 4a flows through the first shunt resistor 6a causing a first voltage drop U₁ at the first shunt resistor 6a, and any electric current I₂ flowing through the second electric power supply line 4b flows through the second shunt resistor 6b causing a second voltage drop U₂ at the second shunt resistor 6b, respectively.

The aircraft ground fault detection circuit 2 further comprises a first voltage detector 8a that is configured for detecting the first voltage drop U₁ over the first shunt resistor 6a, and a second voltage detector 8b that is configured for detecting the second voltage drop U₂ over the second shunt resistor 6b, respectively.

A controller 14 is configured for receiving voltage signals provided by the first and second voltage detectors 8a, 8b indicating the first and second voltage drops U₁, U₂, respectively, and for determining a difference ΔU = U₁ - U₂ between the the first and second voltage drops U₁, U₂. The controller 14 may comprise a micro-controller or micro-processor 15, which may be programmed for providing the desired functionalities.

If the resistance values R₁, R₂ of the first and second shunt resistors 6a, 6b are identical, the difference ΔU = U₁ - U₂ between the first and second voltage drops U₁, U₂ indicates that a first electric current I₁ flowing though the first electric power supply line 4a differs from the second electric current I₂ flowing though the first electric power supply line 4b. Thus, a difference ΔU between the first and second voltage drops U₁, U₂ is an indication for a potential ground fault on the load side of the aircraft solid state power controller 7. In consequence, the controller 14 will drive the first and second electric switching devices 18a, 18b via first and second electric switching device drivers 19a, 19b to switch off in case the difference ΔU between the first and second voltage drops U₁, U₂ exceeds a predefined threshold Uₜₕ.

In practice, however, the resistance values R₁, R₂ of the first and second shunt resistors 6a, 6b are not exactly identical. This may result in an erroneous detection of a ground fault, as a difference ΔU > 0 between the first and second voltage drops U₁, U₂ is detected even when the first and second electric currents I₁, I₂ are identical.

In order to ensure a reliable operation of the aircraft ground fault detection circuit 2, which includes reliably detecting ground faults without causing false alarms, which would result in an unnecessary shutdown of the aircraft solid state power controller, it is beneficial to calibrate the aircraft ground fault detection circuit 2 in order to allow the controller 14 to compensate for differences ΔR = R₁ - R₂ in the resistivities R₁, R₂ of the first and second shunt resistors 6a, 6b.

According to an exemplary embodiment of the invention, the aircraft ground fault detection circuit 2 may be calibrated by applying an electric test voltage Uₜₑₛₜ to the first and second electric power supply lines 4a, 4b.

The electric test voltage Uₜₑₛₜ may be lower than the operating voltage U₀ that is applied by the electric electric power supply 20 to the power supply side nodes 3a, 3b during normal operation of the aircraft solid state power controller 7.

The electric test voltage Uₜₑₛₜ is in particular polarized inversely to the operating voltage U₀. In other words, when the operating voltage U₀ is positive with respect to ground at the first electric power supply line 4a and negative at the second electric power supply line 4b, the electric test voltage Uₜₑₛₜ is negative at the first electric power supply line 4a and positive at the second electric power supply line 4b.

Due to the reversed polarization of the electric test voltage Uₜₑₛₜ, the free-wheeling diode 16 does not block, when the electric test voltage Uₜₑₛₜ is applied to the first and second electric power supply lines 4a, 4b.

As a result, applying the electric test voltage Uₜₑₛₜ to the first and second electric power supply lines 4a, 4b causes an electric test current Iₜₑₛₜ to flow through the first and second electric power supply lines 4a, 4b, the free-wheeling diode 16, and the first and second shunt resistors 6a, 6b. The electric test current Iₜₑₛₜ generates corresponding test voltage drops Uₜₑₛₜ, and Uₜₑₛₜ₂ at the first and second shunt resistors 6a, 6b, respectively.

These test voltage drops Uₜₑₛₜ₁ and Uₜₑₛₜ₂ are detected by the first and second voltage detectors 8a, 8b, respectively. Comparing the two test voltage drops Uₜₑₛₜ₁ and Uₜₑₛₜ₂ with each other allows the controller 14 to determine a difference ΔR = R₁ - R₂ between the resistivities R₁, R₂ of the first and second shunt resistors 6a, 6b.

This difference ΔR between the resistivities R1, R2 may be stored as on offset R_{offset} = ΔR that is to be considered during the normal operation of the aircraft ground fault detection circuit 2. I.e. the offset R_{offset} (difference ΔR between the resistance values R1, R2) may be considered when the voltage drops U₁, U₂ over the first and second shunt resistors 6a, 6b are compared for ground fault detecting in order to prevent a false detection of a non existing ground fault, which could be caused by the difference ΔR = R₁ - R₂ between the resistance values R1, R2 of the first and second shunt resistors 6a, 6b.

In order to apply the test voltage Uₜₑₛₜ to the first and second electric power supply lines 4a, 4b, the aircraft ground fault detection circuit 2 according to an exemplary embodiment of the invention comprises an electric test current power supply 10. The electric test current power supply 10 may, for example, be configured for providing a DC test voltage Uₜₑₛₜ in the range of +/- 10 V to +/- 50 V, in particular a DC test voltage Uₜₑₛₜ in the range of +/- 25 V to +/- 30 V, more particular a DC test voltage Uₜₑₛₜ of +/- 28 V. Voltages U of +/- 28 V are commonly used in aircraft.

The electric test current power supply 10 may comprise a current limiter 11 for limiting the electric test current Iₜₑₛₜ to a predefined value. The load side terminals 11a, 11b of the current limiter 11 are electrically connected to the first and second electric power supply lines 4a, 4b via first and second electric test voltage switching device 12a, 12b. The first and second electric test voltage switching devices 12a, 12b allow the controller 14 to selectively apply the test voltage Uₜₑₛₜ, which is provided by the electric test current power supply 10, to the first and second electric power supply lines 4a, 4b by controlling / switching the first and second electric test voltage switching devices 12a, 12b.

The first and second electric test voltage switching devices 12a, 12b are in particular switched into a low resistive on-state for performing the calibration in order to apply the test voltage Uₜₑₛₜ to the first and second electric power supply lines 4a, 4b. The first and second electric test voltage switching device 12a, 12b are switched into a high resistive off-state after the calibration for separating the test current power supply 10 from the first and second electric power supply lines 4a, 4b.

In order to allow for an undisturbed calibration, the first electric switching device 18a, which is arranged in the first electric power supply line 4a, may be switched off during the calibration for separating the first electric power supply line 4a from the electric electric power supply 20. This prevents currents that are driven by the electric electric power supply 20 from flowing through the aircraft ground fault detection circuit 2.

As in the embodiment depicted in Figure 2, the second electric switching device 18b is arranged in the second electric power supply line 4b between the second shunt resistor 6b and the free-wheeling diode 16, the second electric switching device 18b must be switched on during the calibration in order to allow test current Iₜₑₛₜ to pass through.

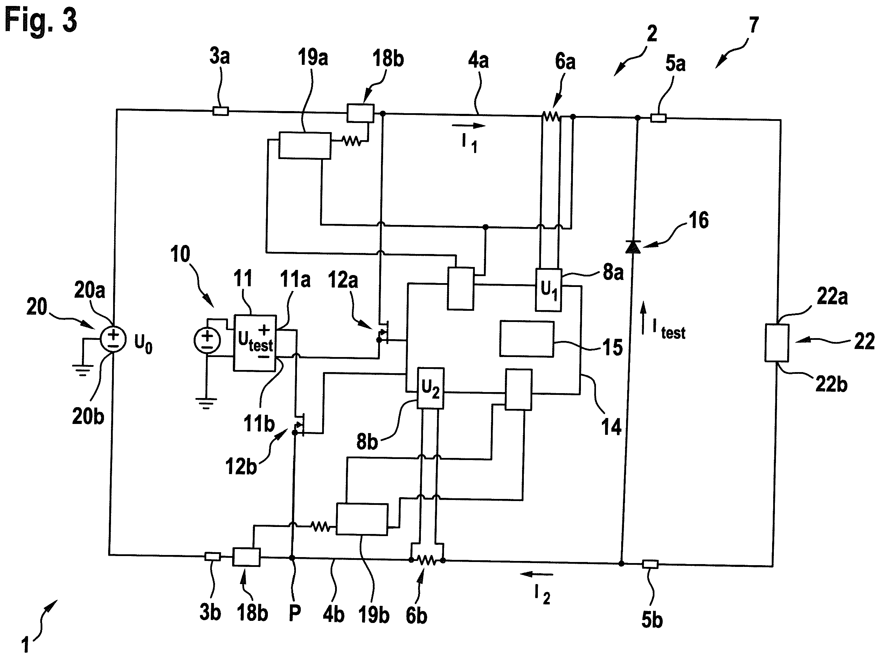

In an alternative configuration, which is depicted in Figure 3, a different type of switching device, for example a field-effect transistor having a p-channel, may be used as the second electric switching device 18b, which allows arranging the second electric switching device 18b between the second power supply side node 3b and the point P, at which the test voltage Uₜₑₛₜ is introduced into the second electric power supply line 4b. In such an embodiment, the first and the second electric switching devices 18a, 18b may be both switched off during the calibration in order to separate the aircraft ground fault detection circuit 2 completely from the electric power supply 20.

While the invention has been described with reference to an exemplary embodiment, it will be understood by those skilled in the art that various changes may be made and equivalents may be substituted for elements thereof without departing from the scope of the invention. In addition, modifications may be made to adapt a particular situation or material to the teachings of the invention without departing from the essential scope thereof as defined by the claims. Therefore, it is intended that the invention is not limited to the particular embodiment disclosed, but that the invention will include all embodiments falling within the scope of the appended claims.

## Claims

1. Aircraft ground fault detection circuit (2) comprising:
a first electric power supply line (4a), and a second electric power supply line (4b);
a first shunt resistor (6a) arranged in the first electric power supply line (4a);
a second shunt resistor (6b) arranged in the second electric power supply line (4b);
a first voltage detector (8a) configured for detecting a first voltage drop (U₁) over the first shunt resistor (6a);
a second voltage detector (8b) configured for detecting a second voltage drop (U₂) over the second shunt resistor (6b);
a first electric switch (18a), which is arranged in the first electric power supply line (4a), and/or a second electric switch (18b), which is arranged in the second electric power supply line (4b);
a dedicated electric test current power supply (10) for applying an electric test voltage (Uₜₑₛₜ) to the first and second electric power supply lines (4a, 4b) causing an electric test current (Iₜₑₛₜ) to flow through the first and second electric power supply lines (4a, 4b) and the first and second shunt resistors (6a, 6b);
a controller (14), which is configured for receiving voltage signals provided by the first and second voltage detectors (8a, 8b) indicating the first and second voltage drops (U₁, U₂), and for switching off at least one of the first and second electric switches (18a, 18b) if the absolute value of the difference (ΔU) between the first and second voltage drops (U₁, U₂) minus an offset voltage (U_{offset}), which is calculated from a difference (ΔR) between the resistivities (R1, R2) of the first and second shunt resistors (6a, 6b), exceeds a predetermined threshold (Uₜₕ);
wherein the controller (14) is further configured for calibrating the aircraft ground fault detection circuit (2) by determining a difference (ΔR) between the resistivities (R₁, R₂) of the first and second shunt resistors (6a, 6b) from the first and second voltage drops voltage drops (U₁, U₂), when the electric test voltage (Uₜₑₛₜ) is applied to the first and second electric power supply lines (4a, 4b), and by calculating the offset voltage (U_{offset}) from the difference (ΔR) between the resistivities (R1, R2) of the first and second shunt resistors (6a, 6b).

2. Aircraft ground fault detection circuit (2) according to claim 1,
wherein the electric test current power supply (10) is configured for applying an electric DC test voltage (Uₜₑₛₜ) in the range of between +/- 10 V and +/- 50 V, in particular an electric DC test voltage (Uₜₑₛₜ) of +/- 28 V to the first and second electric power supply lines (4a, 4b);
wherein the first electric power supply line (4a) is in particular connected to a negative pole (10b) of the electric test current power supply (10), and the second electric power supply line (4b) is in particular connected to a positive pole (10a) of the electric test current power supply (10).

3. Aircraft ground fault detection circuit (2) according to claim 1 or 2,wherein the controller (14) is configured for switching off at least one of the first and second electric switches (18a, 18b) before activating the electric test current power supply (10).

4. Aircraft ground fault detection circuit (2) according to any of claims 1 to 3,
wherein the predetermined threshold (Uₜₕ) corresponds to a difference (ΔU) between the electric currents flowing through the first and second shunt resistors (6a, 6b) in the range of 15 mA to 100 mA, in particular to a difference (ΔI) between the electric currents flowing through the first and second shunt resistors (6a, 6b) of 30 mA.

5. Aircraft ground fault detection circuit (2) according to any of claims 1 to 4, wherein the first and second electric switches (18a, 18b) include field effect transistors (FET), in particular metal-oxide-semiconductor field-effect transistors (MOSFET).

6. Aircraft ground fault detection circuit (2) according to claim 5, wherein the first and second electric switches (18a, 18b) include field effect transistors of the same type, in particular field effect transistors having an n-channel, or field effect transistors having a p-channel.

7. Aircraft ground fault detection circuit (2) according to claim 5, wherein the first electric switch (18a) includes a field effect transistor having an n-channel, and wherein the second electric switch (18b) includes a field effect transistor having a p-channel.

8. Aircraft ground fault detection circuit (2) according to any of claims 1 to 7, wherein the first and second electric switches (18a, 18b) are configured for switching voltages of at least 250 V, in particular voltages of at least 270 V.

9. Aircraft solid state power controller (7) comprising:
two power supply side nodes (3a, 3b), which are configured for being electrically connected to an aircraft electric power supply (20);
two load side nodes (5a, 5b), which are configured for being electrically connected to a least one electric load (22);
a diode (16), which is connected between the load side nodes (5a, 5b) of the aircraft solid state power controller (7); and
an aircraft ground fault detection circuit (2) according to any of claims 1 to 8, which is provided between the power supply side nodes (3a, 3b) and the load side nodes (5a, 5b) of the aircraft solid state power controller (7) for monitoring and controlling the electric currents flowing between the power supply side nodes (3a, 3b) and the load side nodes (5a, 5b) of the aircraft solid state power controller (7).

10. Aircraft solid state power controller (7) according to claim 9, wherein the diode (16) is polarized so that it blocks, when the power supply side nodes (3a, 3b) of the aircraft solid state power controller (7) are electrically connected to a DC aircraft electric power supply (20) for normal operation.

11. Aircraft solid state power controller (7) according to claim 9 or 10, wherein the diode (16) is polarized to allow the electric test current (Iₜₑₛₜ) to flow between the first and second electric power supply lines (4a, 4b), when the electric test current power supply (10) applies the electric test voltage (Uₜₑₛₜ) to the first and second electric power supply lines (4a, 4b); wherein the electric test voltage (Uₜₑₛₜ) applied by the electric test current power supply (10) is in particular polarized opposite to the voltage supplied by the aircraft electric power supply (20).

12. Aircraft comprising an aircraft electric power supply (20) and an aircraft solid state power controller (7) according to any of claims 9 to 11, which is electrically connected to the aircraft electric power supply (20).

13. Method of calibrating an aircraft ground fault detection circuit (2) comprising:
a first electric power supply line (4a), and a second electric power supply line (4b);
a first shunt resistor (6a) arranged in the first electric power supply line (4a);
a second shunt resistor (6b) arranged in the second electric power supply line (4b);
a first voltage detector (8a) which is configured for detecting a first voltage drop (U₁) over the first shunt resistor (6a);
a second voltage detector (8b) which is configured for detecting a second voltage drop (U₂) over the second shunt resistor (6b); and
a controller (14), which is configured for receiving voltage signals provided by the first and second voltage detectors (8a, 8b) indicating the first and second voltage drops (U₁, U₂), and for switching off at least one of the first and second electric switches (18a, 18b) if the absolute value of the difference (ΔU) between the first and second voltage drops (U₁, U₂) minus an offset voltage (U_{offset}), which is calculated from a difference (ΔR) between the resistivities (R1, R2) of the first and second shunt resistors (6a, 6b), exceeds a predetermined threshold (Uₜₕ);
wherein the method includes:
applying an electric test voltage (Uₜₑₛₜ) to the first and second electric power supply lines (4a, 4b) for causing an electric test current to flow through the first and second electric power supply lines (4a, 4b) and the first and second shunt resistors (6a, 6b);
receiving voltage signals from the first and second voltage detectors (8a, 8b) indicating the voltage drop (U₁, U₂) over the respective shunt resistor; and
determining a difference (ΔR) between the resistivities (R1, R2) of the first and second shunt resistors (6a, 6b) from said voltage drops (U₁, U₂); and
calculating an offset voltage (U_{offset}) from the difference (ΔR) between the resistivities (R1, R2) of the first and second shunt resistors (6a, 6b).

14. Method of calibrating an aircraft ground fault detection circuit (2) according to claim 13, wherein the aircraft ground fault detection circuit (2) comprises a diode (16), which is connected between the first and second electric power supply lines (4a, 4b), and wherein the electric test voltage (Uₜₑₛₜ) applied to the first and second electric power supply lines (4a, 4b) is polarized so that the electric test current (Iₜₑₛₜ) flows through the diode (16).

15. Method of operating an aircraft ground fault detection circuit (2) according to any of claims 3 to 8,
wherein the method includes calibrating the aircraft ground fault detection circuit (2) with a method according to claim 13 or 14;
wherein the method further includes
measuring and comparing the electric voltage drops (U₁, U₂) at the first and second shunt resistors (6a, 6b) with each other; and
switching off at least one of the first and second electric switches (18a, 18b) in case the absolute value of the difference (ΔU) between the first and second voltage drops (U₁, U₂) minus the offset voltage (U_{offset}) exceeds a predetermined threshold (Uₜₕ);
wherein the predetermined threshold (Uₜₕ) corresponds in particular to a difference (ΔU) between the electric currents flowing through the first and second shunt resistors (6a, 6b) in the range of 15 mA to 100 mA, more particular to a difference (ΔI) between the electric currents flowing through the first and second shunt resistors (6a, 6b) of 30 mA.

## Patentansprüche

1. Luftfahrzeugerdschlusserkennungsschaltung (2), umfassend:
eine erste elektrische Leistungsversorgungsleitung (4a) und eine zweite elektrische Leistungsversorgungsleitung (4b);
einen ersten Shuntwiderstand (6a), der in der ersten elektrischen Leistungsversorgungsleitung (4a) angeordnet ist;
einen zweiten Shuntwiderstand (6b), der in der zweiten elektrischen Leistungsversorgungsleitung (4b) angeordnet ist;
einen ersten Spannungsdetektor (8a), der zum Detektieren eines ersten Spannungsabfalls (U₁) über dem ersten Shuntwiderstand (6a) ausgelegt ist;
einen zweiten Spannungsdetektor (8b), der zum Detektieren eines zweiten Spannungsabfalls (U₂) über dem zweiten Shuntwiderstand (6b) ausgelegt ist;
einen ersten elektrischen Schalter (18a), der in der ersten elektrischen Leistungsversorgungsleitung (4a) angeordnet ist, und/oder einen zweiten elektrischen Schalter (18b), der in der zweiten elektrischen Leistungsversorgungsleitung (4b) angeordnet ist;
eine dedizierte elektrische Prüfstromleistungsversorgung (10) zum Anlegen einer elektrischen Prüfspannung (Uₜₑₛₜ) an die erste und die zweite elektrische Leistungsversorgungsleitung (4a, 4b), wodurch bewirkt wird, dass ein elektrischer Prüfstrom (Iₜₑₛₜ) durch die erste und die zweite elektrische Leistungsversorgungsleitung (4a, 4b) und den ersten und den zweiten Shuntwiderstand (6a, 6b) fließt;
eine Steuerung (14), die zum Empfangen von Spannungssignalen, die von dem ersten und dem zweiten Spannungsdetektor (8a, 8b) bereitgestellt werden und den ersten und den zweiten Spannungsabfall (U₁, U₂) angeben, und zum Abschalten mindestens eines von dem ersten und dem zweiten elektrischen Schalter (18a, 18b), wenn der Absolutwert der Differenz (ΔU) zwischen dem ersten und dem zweiten Spannungsabfall (U₁, U₂) abzüglich einer Offsetspannung (U_{offset}), die aus einer Differenz (ΔR) zwischen den Widerstandswerten (R1, R2) des ersten und des zweiten Shuntwiderstands (6a, 6b) berechnet wird, einen vorbestimmten Schwellenwert (Uₜₕ) überschreitet, ausgelegt ist;
wobei die Steuerung (14) ferner zum Kalibrieren der Luftfahrzeugerdschlusserkennungsschaltung (2) durch Bestimmen einer Differenz (ΔR) zwischen den Widerstandswerten (R₁, R₂) des ersten und des zweiten Shuntwiderstands (6a, 6b) aus dem ersten und dem zweiten Spannungsabfall (U₁, U₂), wenn die elektrische Prüfspannung (Uₜₑₛₜ) an die erste und die zweite elektrische Leistungsversorgungsleitung (4a, 4b) angelegt wird, und durch Berechnen der Offsetspannung (U_{offset}) aus der Differenz (ΔR) zwischen den Widerstandswerten (R1, R2) des ersten und des zweiten Shuntwiderstands (6a, 6b) ausgelegt ist.

2. Luftfahrzeugerdschlusserkennungsschaltung (2) nach Anspruch 1,
wobei die elektrische Prüfstromleistungsversorgung (10) zum Anlegen einer elektrischen DC-Prüfspannung (Uₜₑₛₜ) in dem Bereich zwischen ± 10 V und ± 50 V, insbesondere einer elektrischen DC-Prüfspannung (Uₜₑₛₜ) von ± 28 V, an die erste und die zweite elektrische Leistungsversorgungsleitung (4a, 4b) ausgelegt ist;
wobei die erste elektrische Leistungsversorgungsleitung (4a) insbesondere mit einem Minuspol (10b) der elektrischen Prüfstromleistungsversorgung (10) verbunden ist und die zweite elektrische Leistungsversorgungsleitung (4b) insbesondere mit einem Pluspol (10a) der elektrischen Prüfstromleistungsversorgung (10) verbunden ist.

3. Luftfahrzeugerdschlusserkennungsschaltung (2) nach Anspruch 1 oder 2, wobei die Steuerung (14) zum Abschalten mindestens eines von dem ersten und dem zweiten elektrischen Schalter (18a, 18b) vor einem Aktivieren der elektrischen Prüfstromleistungsversorgung (10) ausgelegt ist.

4. Luftfahrzeugerdschlusserkennungsschaltung (2) nach einem der Ansprüche 1 bis 3,
wobei der vorbestimmte Schwellenwert (Uₜₕ) einer Differenz (ΔU) zwischen den durch den ersten und den zweiten Shuntwiderstand (6a, 6b) fließenden elektrischen Strömen in dem Bereich von 15 mA bis 100 mA, insbesondere einer Differenz (ΔI) zwischen den durch den ersten und den zweiten Shuntwiderstand (6a, 6b) fließenden elektrischen Strömen von 30 mA, entspricht.

5. Luftfahrzeugerdschlusserkennungsschaltung (2) nach einem der Ansprüche 1 bis 4, wobei der erste und der zweite elektrische Schalter (18a, 18b) Feldeffekttransistoren (FET), insbesondere Metalloxid-Halbleiter-Feldeffekttransistoren (MOSFET), beinhalten.

6. Luftfahrzeugerdschlusserkennungsschaltung (2) nach Anspruch 5, wobei der erste und der zweite elektrische Schalter (18a, 18b) Feldeffekttransistoren derselben Art, insbesondere Feldeffekttransistoren, die einen n-Kanal aufweisen, oder Feldeffekttransistoren, die einen p-Kanal aufweisen, beinhalten.

7. Luftfahrzeugerdschlusserkennungsschaltung (2) nach Anspruch 5, wobei der erste elektrische Schalter (18a) einen Feldeffekttransistor, der einen n-Kanal aufweist, beinhaltet und wobei der zweite elektrische Schalter (18b) einen Feldeffekttransistor, der einen p-Kanal aufweist, beinhaltet.

8. Luftfahrzeugerdschlusserkennungsschaltung (2) nach einem der Ansprüche 1 bis 7, wobei der erste und der zweite elektrische Schalter (18a, 18b) zum Schalten von Spannungen von mindestens 250 V, insbesondere Spannungen von mindestens 270 V, ausgelegt sind.

9. Luftfahrzeugfestkörperleistungsregler (7), umfassend:
zwei leistungsversorgungsseitige Knoten (3a, 3b), die dazu ausgelegt sind, mit einer elektrischen Luftfahrzeugleistungsversorgung (20) elektrisch verbunden zu sein;
zwei lastseitige Knoten (5a, 5b), die dazu ausgelegt sind, mit mindestens einer elektrischen Last (22) elektrisch verbunden zu sein;
eine Diode (16), die zwischen den lastseitigen Knoten (5a, 5b) des Luftfahrzeugfestkörperleistungsreglers (7) verbunden ist; und
eine Luftfahrzeugerdschlusserkennungsschaltung (2) nach einem der Ansprüche 1 bis 8, die zwischen den leistungsversorgungsseitigen Knoten (3a, 3b) und den lastseitigen Knoten (5a, 5b) des Luftfahrzeugfestkörperleistungsreglers (7) zum Überwachen und Steuern der elektrischen Ströme, die zwischen den leistungsversorgungsseitigen Knoten (3a, 3b) und den lastseitigen Knoten (5a, 5b) des Luftfahrzeugfestkörperleistungsreglers (7) fließen, bereitgestellt ist.

10. Luftfahrzeugfestkörperleistungsregler (7) nach Anspruch 9, wobei die Diode (16) so gepolt ist, dass sie sperrt, wenn die leistungsversorgungsseitigen Knoten (3a, 3b) des Luftfahrzeugfestkörperleistungsreglers (7) für einen Normalbetrieb mit einer elektrischen DC-Luftfahrzeugleistungsversorgung (20) elektrisch verbunden sind.

11. Luftfahrzeugfestkörperleistungsregler (7) nach Anspruch 9 oder 10, wobei die Diode (16) gepolt ist, um es dem elektrischen Prüfstrom (Iₜₑₛₜ) zu ermöglichen, zwischen der ersten und der zweiten elektrischen Leistungsversorgungsleitung (4a, 4b) zu fließen, wenn die elektrische Prüfstromleistungsversorgung (10) die elektrische Prüfspannung (Uₜₑₛₜ) an die erste und die zweite elektrische Leistungsversorgungsleitung (4a, 4b) anlegt; wobei die elektrische Prüfspannung (Uₜₑₛₜ), die durch die elektrische Prüfstromleistungsversorgung (10) angelegt wird, insbesondere entgegengesetzt zu der Spannung, die von der elektrischen Luftfahrzeugleistungsversorgung (20) zugeführt wird, gepolt ist.

12. Luftfahrzeug, umfassend eine elektrische Luftfahrzeugleistungsversorgung (20) und einen Luftfahrzeugfestkörperleistungsregler (7) nach einem der Ansprüche 9 bis 11, der mit der elektrischen Luftfahrzeugleistungsversorgung (20) elektrisch verbunden ist.

13. Verfahren zum Kalibrieren einer Luftfahrzeugerdschlusserkennungsschaltung (2), umfassend:
eine erste elektrische Leistungsversorgungsleitung (4a) und eine zweite elektrische Leistungsversorgungsleitung (4b);
einen ersten Shuntwiderstand (6a), der in der ersten elektrischen Leistungsversorgungsleitung (4a) angeordnet ist;
einen zweiten Shuntwiderstand (6b), der in der zweiten elektrischen Leistungsversorgungsleitung (4b) angeordnet ist;
einen ersten Spannungsdetektor (8a), der zum Detektieren eines ersten Spannungsabfalls (U₁) über dem ersten Shuntwiderstand (6a) ausgelegt ist;
einen zweiten Spannungsdetektor (8b), der zum Detektieren eines zweiten Spannungsabfalls (U₂) über dem zweiten Shuntwiderstand (6b) ausgelegt ist; und
eine Steuerung (14), die zum Empfangen von Spannungssignalen, die von dem ersten und dem zweiten Spannungsdetektor (8a, 8b) bereitgestellt werden und den ersten und den zweiten Spannungsabfall (U₁, U₂) angeben, und zum Abschalten mindestens eines von dem ersten und dem zweiten elektrischen Schalter (18a, 18b), wenn der Absolutwert der Differenz (ΔU) zwischen dem ersten und dem zweiten Spannungsabfall (U₁, U₂) abzüglich einer Offsetspannung (U_{offset}), die aus einer Differenz (ΔR) zwischen den Widerstandswerten (R1, R2) des ersten und des zweiten Shuntwiderstands (6a, 6b) berechnet wird, einen vorbestimmten Schwellenwert (Uₜₕ) überschreitet, ausgelegt ist;
wobei das Verfahren beinhaltet:
Anlegen einer elektrischen Prüfspannung (Uₜₑₛₜ) an die erste und die zweite elektrische Leistungsversorgungsleitung (4a, 4b) zum Bewirken, dass ein elektrischer Prüfstrom durch die erste und die zweite elektrische Leistungsversorgungsleitung (4a, 4b) und den ersten und den zweiten Shuntwiderstand (6a, 6b) fließt;
Empfangen von Spannungssignalen von dem ersten und dem zweiten Spannungsdetektor (8a, 8b), die den Spannungsabfall (U₁, U₂) über dem jeweiligen Shuntwiderstand angeben; und
Bestimmen einer Differenz (ΔR) zwischen den Widerstandswerten (R1, R2) des ersten und des zweiten Shuntwiderstands (6a, 6b) aus den Spannungsabfällen (U₁, U₂); und
Berechnen einer Offsetspannung (U_{offset}) aus der Differenz (ΔR) zwischen den Widerstandswerten (R1, R2) des ersten und des zweiten Shuntwiderstands (6a, 6b).

14. Verfahren zum Kalibrieren einer Luftfahrzeugerdschlusserkennungsschaltung (2) nach Anspruch 13, wobei die Luftfahrzeugerdschlusserkennungsschaltung (2) eine Diode (16), die zwischen der ersten und der zweiten elektrischen Leistungsversorgungsleitung (4a, 4b) verbunden ist, umfasst und wobei die elektrische Prüfspannung (Uₜₑₛₜ), die an die erste und die zweite elektrische Leistungsversorgungsleitung (4a, 4b) angelegt wird, so gepolt ist, dass der elektrische Prüfstrom (Iₜₑₛₜ) durch die Diode (16) fließt.

15. Verfahren zum Betreiben einer Luftfahrzeugerdschlusserkennungsschaltung (2) nach einem der Ansprüche 3 bis 8,
wobei das Verfahren ein Kalibrieren der Luftfahrzeugerdschlusserkennungsschaltung (2) mit einem Verfahren nach Anspruch 13 oder 14 beinhaltet;
wobei das Verfahren ferner beinhaltet
Messen und Miteinandervergleichen der elektrischen Spannungsabfälle (U₁, U₂) an dem ersten und dem zweiten Shuntwiderstand (6a, 6b); und
Abschalten mindestens eines von dem ersten und dem zweiten elektrischen Schalter (18a, 18b), falls der Absolutwert der Differenz (ΔU) zwischen dem ersten und dem zweiten Spannungsabfall (U₁, U₂) abzüglich der Offsetspannung (U_{offset}) einen vorbestimmten Schwellenwert (Uₜₕ) überschreitet;
wobei der vorbestimmte Schwellenwert (Uₜₕ) insbesondere einer Differenz (ΔU) zwischen den durch den ersten und den zweiten Shuntwiderstand (6a, 6b) fließenden elektrischen Strömen in dem Bereich von 15 mA bis 100 mA, ganz besonders einer Differenz (ΔI) zwischen den durch den ersten und den zweiten Shuntwiderstand (6a, 6b) fließenden elektrischen Strömen von 30 mA, entspricht.

## Revendications

1. Circuit de détection de défaut de mise à la terre pour aéronef (2) comprenant :
une première ligne d'alimentation électrique (4a) et une seconde ligne d'alimentation électrique (4b) ;
une première résistance shunt (6a) disposée dans la première ligne d'alimentation électrique (4a) ;
une seconde résistance shunt (6b) disposée dans la seconde ligne d'alimentation électrique (4b) ;
un premier détecteur de tension (8a) configuré pour détecter une première chute de tension (U₁) sur la première résistance shunt (6a) ;
un second détecteur de tension (8b) configuré pour détecter une seconde chute de tension (U₂) sur la seconde résistance shunt (6b) ;
un premier interrupteur électrique (18a), qui est disposé sur la première ligne d'alimentation électrique (4a), et/ou un second interrupteur électrique (18b), qui est disposé sur la seconde ligne d'alimentation électrique (4b) ;
une alimentation électrique dédiée au courant de test (10) pour appliquer une tension de test électrique (Uₜₑₛₜ) aux première et seconde lignes d'alimentation électrique (4a, 4b) provoquant un courant de test électrique (Iₜₑₛₜ) à travers les première et seconde lignes d'alimentation électrique (4a, 4b) et les première et seconde résistances shunt (6a, 6b) ;
un contrôleur (14), configuré pour recevoir des signaux de tension fournis par les premier et second détecteurs de tension (8a, 8b) indiquant les première et seconde chutes de tension (U₁, U₂), et pour couper au moins l'un des premier et
second interrupteurs électriques (18a, 18b) si la valeur absolue de la différence (ΔU) entre les première et seconde chutes de tension (U₁, U₂) moins une tension de décalage (U_{décalage}), qui est calculée à partir d'une différence (ΔR) entre les résistivités (R1, R2) des première et seconde résistances shunt (6a, 6b), dépasse un seuil prédéterminé (Uₛₑᵤᵢₗ) ;
dans lequel le contrôleur (14) est en outre configuré pour étalonner le circuit de détection de défaut de mise à la terre pour aéronef (2) en déterminant une différence (ΔR) entre les résistivités (R₁, R₂) des première et seconde résistances shunt (6a, 6b) à partir des première et seconde chutes de tension (U₁, U₂), lorsque la tension de test électrique (Uₜₑₛₜ) est appliquée aux première et seconde lignes d'alimentation électrique (4a, 4b), et en calculant la tension de décalage (U_{décalage}) à partir de la différence (ΔR) entre les résistivités (R1, R2) des première et seconde résistances shunt (6a, 6b).

2. Circuit de détection de défaut de mise à la terre pour aéronef (2) selon la revendication 1,
dans lequel l'alimentation électrique de courant de test (10) est configurée pour appliquer une tension de test électrique CC (Uₜₑₛₜ) dans la plage comprise entre +/- 10 V et +/- 50 V, en particulier une tension de test électrique CC (Uₜₑₛₜ) de +/-28 V aux première et seconde lignes d'alimentation électrique (4a, 4b) ;
dans lequel la première ligne d'alimentation électrique (4a) est en particulier connectée à un pôle négatif (10b) de l'alimentation électrique de courant de test (10), et la seconde ligne d'alimentation électrique (4b) est en particulier connectée à un pôle positif (10a) de l'alimentation électrique de courant de test (10).

3. Circuit de détection de défaut de mise à la terre pour aéronef (2) selon la revendication 1 ou 2, dans lequel le contrôleur (14) est configuré pour couper au moins l'un des premier et second interrupteurs électriques (18a, 18b) avant d'activer l'alimentation électrique de courant de test (10).

4. Circuit de détection de défaut de mise à la terre pour aéronef (2) selon l'une quelconque des revendications 1 à 3, dans lequel le seuil prédéterminé (Uₛₑᵤᵢₗ) correspond à une différence (ΔU) entre les courants électriques circulant à travers les première et seconde résistances shunt (6a, 6b) dans la plage de 15 mA à 100 mA, en particulier à une différence (ΔI) entre les courants électriques circulant à travers les première et seconde résistances shunt (6a, 6b) de 30 mA.

5. Circuit de détection de défaut de mise à la terre pour aéronef (2) selon l'une quelconque des revendications 1 à 4, dans lequel les premier et second commutateurs électriques (18a, 18b) comporte des transistors à effet de champ (FET), en particulier des transistors à effet de champ métal-oxyde-semiconducteur (MOSFET).

6. Circuit de détection de défaut de mise à la terre pour aéronef (2) selon la revendication 5, dans lequel les premier et second commutateurs électriques (18a, 18b) comportent des transistors à effet de champ du même type, en particulier des transistors à effet de champ à canal n ou des transistors à effet de champ à canal p.

7. Circuit de détection de défaut de mise à la terre pour aéronef (2) selon la revendication 5, dans lequel le premier interrupteur électrique (18a) comporte un transistor à effet de champ à canal n, et dans lequel le second interrupteur électrique (18b) comporte un transistor à effet de champ à canal p.

8. Circuit de détection de défaut de mise à la terre pour aéronef (2) selon l'une quelconque des revendications 1 à 7, dans lequel les premier et second commutateurs électriques (18a, 18b) sont configurés pour des tensions de commutation d'au moins 250 V, en particulier des tensions d'au moins 270 V.

9. Contrôleur de puissance à semi-conducteurs (7) pour aéronef comprenant :
deux nœuds côté alimentation (3a, 3b), qui sont configurés pour être connectés électriquement à une alimentation électrique (20) d'aéronef ;
deux nœuds côté charge (5a, 5b), qui sont configurés pour être connectés électriquement à au moins une charge électrique (22) ;
une diode (16), qui est connectée entre les nœuds côté charge (5a, 5b) du contrôleur de puissance à semi-conducteurs (7) pour aéronef ; et
un circuit de détection de défaut de mise à la terre pour aéronef (2) selon l'une quelconque des revendications 1 à 8, qui est prévu entre les nœuds côté alimentation (3a, 3b) et les nœuds côté charge (5a, 5b) du contrôleur de puissance à semi-conducteurs (7) pour aéronef afin de surveiller et contrôler les courants électriques circulant entre les nœuds côté alimentation (3a, 3b) et les nœuds côté charge (5a, 5b) du contrôleur de puissance à semi-conducteurs (7) pour aéronef.

10. Contrôleur de puissance à semi-conducteurs (7) pour aéronef selon la revendication 9, dans lequel la diode (16) est polarisée de manière à bloquer, lorsque les nœuds côté alimentation (3a, 3b) du contrôleur de puissance à semi-conducteurs (7) pour aéronef sont connectés électriquement à une alimentation électrique CC (20) d'aéronef pour un fonctionnement normal.

11. Contrôleur de puissance à semi-conducteurs (7) pour aéronef selon la revendication 9 ou 10, dans lequel la diode (16) est polarisée pour permettre au courant de test électrique (Iₜₑₛₜ) de circuler entre les première et seconde lignes d'alimentation électrique (4a, 4b), lorsque l'alimentation électrique de courant de test (10) applique la tension de test électrique (Uₜₑₛₜ) aux première et seconde lignes d'alimentation électrique (4a, 4b) ; dans lequel la tension de test électrique (Uₜₑₛₜ) appliquée par l'alimentation électrique de courant de test (10) est en particulier polarisée à l'opposé de la tension fournie par l'alimentation électrique (20) d'aéronef.

12. Aéronef comprenant une alimentation électrique (20) d'aéronef et un contrôleur de puissance à semi-conducteurs (7) pour aéronef selon l'une quelconque des revendications 9 à 11, qui est électriquement connecté à l'alimentation électrique (20) d'aéronef.

13. Procédé d'étalonnage d'un circuit de détection de défaut de mise à la terre pour aéronef (2) comprenant :
une première ligne d'alimentation électrique (4a) et une seconde ligne d'alimentation électrique (4b) ;
une première résistance shunt (6a) disposée dans la première ligne d'alimentation électrique (4a) ;
une seconde résistance shunt (6b) disposée dans la seconde ligne d'alimentation électrique (4b) ;
un premier détecteur de tension (8a) qui est configuré pour détecter une première chute de tension (U₁) sur la première résistance shunt (6a) ;
un second détecteur de tension (8b) qui est configuré pour détecter une seconde chute de tension (U₂) sur la seconde résistance shunt (6b) ; et
un contrôleur (14), qui est configuré pour recevoir des signaux de tension fournis par les premier et second détecteurs de tension (8a, 8b) indiquant les première et seconde chutes de tension (U₁, U₂), et pour couper au moins l'un des premier et second interrupteurs électriques (18a, 18b) si la valeur absolue de la différence (ΔU) entre les première et seconde chutes de tension (U₁, U₂) moins une tension de décalage (U_{décalage}), qui est calculée à partir d'une différence (ΔR) entre les résistivités (R1, R2) des première et seconde résistances shunt (6a, 6b), dépasse un seuil prédéterminé (Uₛₑᵤᵢₗ) ;
dans lequel le procédé comporte :
l'application d'une tension de test électrique (Uₜₑₛₜ) aux première et seconde lignes d'alimentation électrique (4a, 4b) provoquant la circulation d'un courant de test électrique à travers les première et seconde lignes d'alimentation électrique (4a, 4b) et les première et seconde résistances shunt (6a, 6b) ;
la réception de signaux de tension provenant des premier et second détecteurs de tension (8a, 8b) indiquant la chute de tension (U₁, U₂) aux bornes de la résistance shunt respective ; et
la détermination d'une différence (ΔR) entre les résistivités (R1, R2) des première et seconde résistances shunt (6a, 6b) à partir desdites chutes de tension (U₁,U₂) ; et
le calcul d'une tension de décalage (U_{décalage}) à partir de la différence (ΔR) entre les résistivités (R1, R2) des première et seconde résistances shunt (6a, 6b).

14. Procédé d'étalonnage d'un circuit de détection de défaut de mise à la terre pour aéronef (2) selon la revendication 13, dans lequel le circuit de détection de défaut de mise à la terre pour aéronef (2) comprend une diode (16), qui est connectée entre les première et seconde lignes d'alimentation électrique (4a, 4b), et dans lequel la tension de test électrique (Uₜₑₛₜ) appliquée aux première et seconde lignes d'alimentation électrique (4a, 4b) est polarisée de sorte que le courant de test électrique (Iₜₑₛₜ) circule à travers la diode (16).

15. Procédé de fonctionnement d'un circuit de détection de défaut de mise à la terre pour aéronef (2) selon l'une quelconque des revendications 3 à 8,
dans lequel le procédé comporte l'étalonnage du circuit de détection de défaut de mise à la terre pour aéronef (2) avec un procédé selon la revendication 13 ou 14 ;
dans lequel le procédé comporte en outre
la mesure et la comparaison des chutes de tension électrique (U₁, U₂) aux première et seconde résistances shunt (6a, 6b) entre elles ; et
la coupure d'au moins l'un des premier et second interrupteurs électriques (18a, 18b) dans le cas où la valeur absolue de la différence (ΔU) entre les première et seconde chutes de tension (U₁, U₂) moins la tension de décalage (U_{décalage}) dépasse un seuil prédéterminé (Uₛₑᵤᵢₗ) ;
dans lequel le seuil prédéterminé (Uₛₑᵤᵢₗ) correspond en particulier à une différence (ΔU) entre les courants électriques circulant à travers les première et seconde résistances shunt (6a, 6b) dans la plage de 15 mA à 100 mA, en particulier à une différence (ΔI) entre les courants électriques circulant à travers les première et seconde résistances shunt (6a, 6b) de 30 mA.
